Europäisches Patentamt

European Patent Office

Office européen des brevets

(19)

(11) Publication number: **0 237 698 B1**

# EUROPEAN PATENT SPECIFICATION

(12)

(45) Date of publication of patent specification: **22.04.92**　(51) Int. Cl.⁵: **G12B 9/08**

(21) Application number: **87100160.8**

(22) Date of filing: **16.08.83**

(60) Publication number of the earlier application in accordance with Art.76 EPC: **0 102 217**

(54) **Electronic test head positioner for test systems.**

(30) Priority: **25.08.82 US 411311**
**11.08.83 US 522635**

(43) Date of publication of application:
**23.09.87 Bulletin  87/39**

(45) Publication of the grant of the patent:
**22.04.92 Bulletin  92/17**

(84) Designated Contracting States:
**AT BE CH DE FR GB IT LI LU NL SE**

(56) References cited:
**DE-A- 3 048 045**
**GB-A- 2 074 337**

(73) Proprietor: **InTest Corporation**
**12 Springdale Road**
**Cherry Hill New Jersey 08003(US)**

(72) Inventor: **Smith, Nathan R.**
**114 Nanticoke Court**
**Vincentown New Jersey 08088(US)**

(74) Representative: **Pacitti, Pierpaolo A.M.E. et al**
**Murgitroyd and Company Mitchell House 333 Bath Street**
**Glasgow G2 4ER Scotland(GB)**

EP 0 237 698 B1

**Description**

This invention relates to the field of art of electronic test head positioners.

In the automatic testing of integrated circuits (IC) and other electronic devices, special device handlers have been used which place the device to be tested in position. The electronic testing itself is provided by a large and expensive automatic testing system which includes a test head which has been required to connect to and dock with the device handler. In such testing systems, the test head has been usually very heavy in the order of 34 to 136 kilograms. The reason for this heaviness is that the test head uses high speed electronic timing signals so that the electronic circuits must be located as close as possible to the device under test. Accordingly, the test head has been densely packaged with electronic circuits in order to achieve the high speed testing of the sophisticated devices.

The prior art has left much to be desired in providing a manipulator or positioner to easily move the heavy test head accurately into position with respect to the device handler mechanism. In some prior positioners the test head has been positioned by means of lead screws and rotating and sliding mechanisms each movable one at a time. These prior systems left much to be desired in that they did not provide all of the degrees of freedom necessary for easy and accurate docking with the handler. The user has had to move the heavy device handler or the heavy positioner itself in order to provide alignment. Other prior art manipulating systems have used motors to drive the lead screws in the up-down direction, i.e., such as that system shown in Wang et al. U.S. Patent No. 4,132,218. Such a motor driven lead screw or even a hand driven one provides the possibility of damaging either the test head socket connections or the connections which are on the device handler due to overstressing. One prior art system, that shown in Pugh et al GB-A-2074337, is an adjustable support for optical or other instruments. Because this system allows for relative vertical movement between a clamping device and the main support axis, it could present hazards when it is used for heavy equipment.

Another disadvantage of the prior art systems is that they are large and take up a considerable amount of floor space which is at a premium in test facilities. A further difficulty of large prior systems has involved the cable which connects the test system to the test head which is usually short, cumbersome and fragile. Accordingly as a result of their size and construction, prior systems could not be moved sufficiently close to the test system.

For purposes of considering patentability, a brief patentability search was conducted. The patents identified to be of possible interest in the search were:

| Patent No. | Inventor |
| --- | --- |
| 4,199,294 | Streck et al. |
| 4,062,455 | Carl Flatau |
| 4,132,318 | Wang et al. |
| 3,873,148 | Robert Kennicuit |
| 4,076,131 | Dahlstrom et al. |
| 4,188,166 | Moreau et al. |
| 4,273,506 | Thomson et al. |
| 4,299,529 | Inaha et al. |
| 4,264,266 | Hans Trechsel |
| 3,791,052 | Cornelis Van Der Lely |
| 3,826,383 | Hans Richter |
| 4,303,368 | Dent et al. |
| GB-A-2074337 | Pugh et al. |

Accordingly, an object of the present invention is an electronic test head positioner that has six degrees of freedom and provides a substantially weightless condition to the test head which may be manipulated by hand for easy and accurate docking and undocking of the test head with the device handler.

Another object of the invention is an electronic test head positioner formed by a column rising vertically from a base which takes little room on the floor with respect to the test system.

These objects are achieved by a system according to claim 1.

Figs. 1-3 are perspective views of a test head positioner system in accordance with the present invention;

Fig. 4 is an elevational sectional view of Fig. 3;

Fig. 5 is a diagrammatic view of the system of Figs. 1-3 showing the docking of a test head with a mechanism plate of a handler;

Fig. 6 diagrammatically shows the six degrees of freedom of the system of Figs. 1-3;

Fig. 7 is another embodiment of the present invention in which a pressurized cylinder is used;

Fig. 8 is a perspective cut away view of a portion of Fig. 3;

Figs. 9 and 10 are perspective views of a further embodiment in which the vertical column of Figs. 1-3 is replaced by a vertical cylindrical support tube; and

Fig. 11 is a perspective view of still another embodiment having a vertical tube of Figs. 9 and 10.

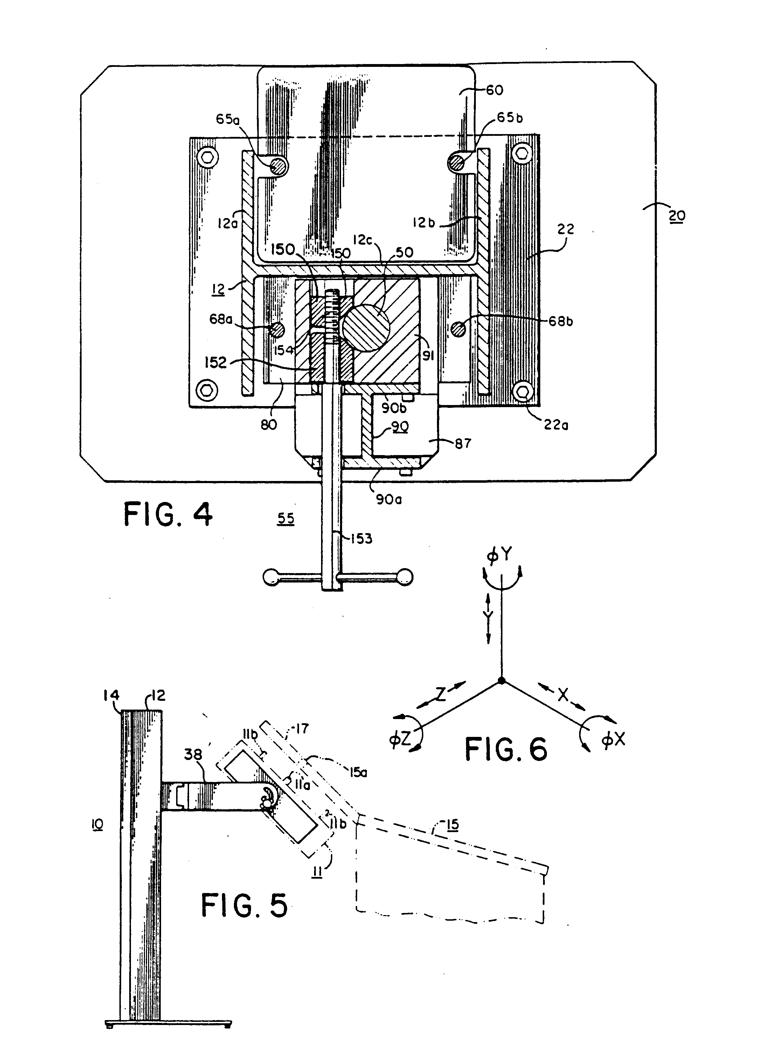

Referring now to Fig. 5, there is shown a test head positioner system 10 in accordance with the invention. As shown, positioner system 10 carries a test head 11 for a test system for docking with a mechanism plate 17 of an integrated circuit handler 15. It will be understood that other electronic devices may be handled by device handler such as transistors, chips or dies, etc. In operation, positioner system 10 is moved manually in a substantially weightless condition to manipulate the heavy test head 11 accurately and precisely and dock it into the mechanism plate 17. In docking, location pins 11b are inserted into corresponding openings in plate 17 and test connector 11a enters and mates with a connector for a device 15a to be tested. The position of test head 11 may be accurately manipulated in a substantially weightless condition to another position with six degrees of freedom substantially extensible in the horizontal plane to dock with other mechanism plates in any position. For example, mechanism plates for probers or handlers may be anywhere from a horizontal plane to a vertical plane.

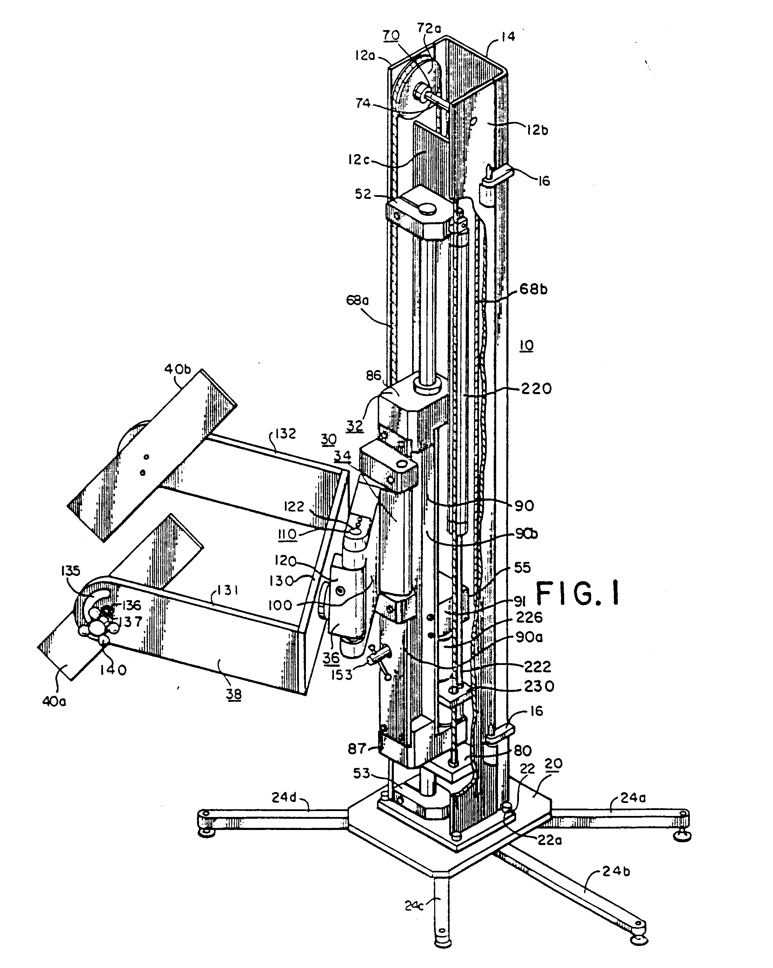

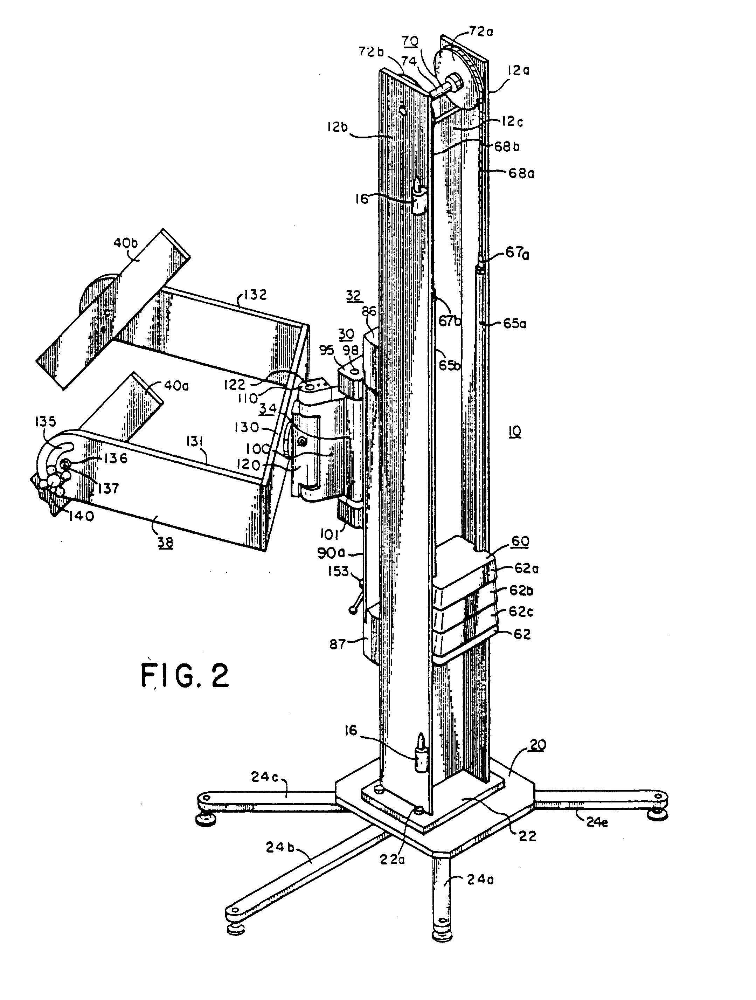

The details of system 10 are shown in Figs. 1-3 in which an H-shaped beam forms a vertical column 12. Column 12 has opposing walls 12a,b with a flange 12c connecting the two walls together. Column 12 is suported at its bottom by a base assembly 20 having a base plate 22 and outwardly extending legs 24a-e. Column 12 is secured to plate 22 by bolts 22a for example. The rear of column 12 is closed by a U-shaped door 14 hinged to wall 12b by way of hinges 16.

Test head 11 is supported and manipulated in its docking by a positioner arm assembly 30 which moves vertically on a main shaft 50. Assembly 30 comprises a main arm assembly 32, a forearm assembly 34, a wrist joint assembly 36, a cradle assembly 38 and test head adapter plates 40a, b. Main shaft 50 is secured by opposing pillow blocks 52,53.

Positioner arm assembly 30 is counterbalanced to ride vertically on main shaft 50 by a counter weight assembly 60 having a weight carriage 62 which moves vertically in either direction within the rear section of column 12. Carriage 62 has vertically extending carriage shafts 65a,b secured thereto and carries removable weights 62a-c. Weights 62a-c exactly counterbalance the weight of assembly 30 and test head 11 so that they are substantially weightless.

The upper ends of shafts 65a,b threadedly receive members 67a,b swaged to respective ends of cables 68a,b received within grooves of pulleys 72a,b of assembly 70. Shaft 74 permits the rotation of pulleys 72a,b and the shaft is received at an upper end section of column 12. Cables 68a,b extend downwardly along the inner surface of walls 12a,b through openings in a plate 230 and are securely fastened by way of swaged members to a lift block 80 positioned under main arm assembly 32. Block 80 has an opening for receiving shaft 50 and the block slides along web 12c and is this prevented from rotating around shaft 50.

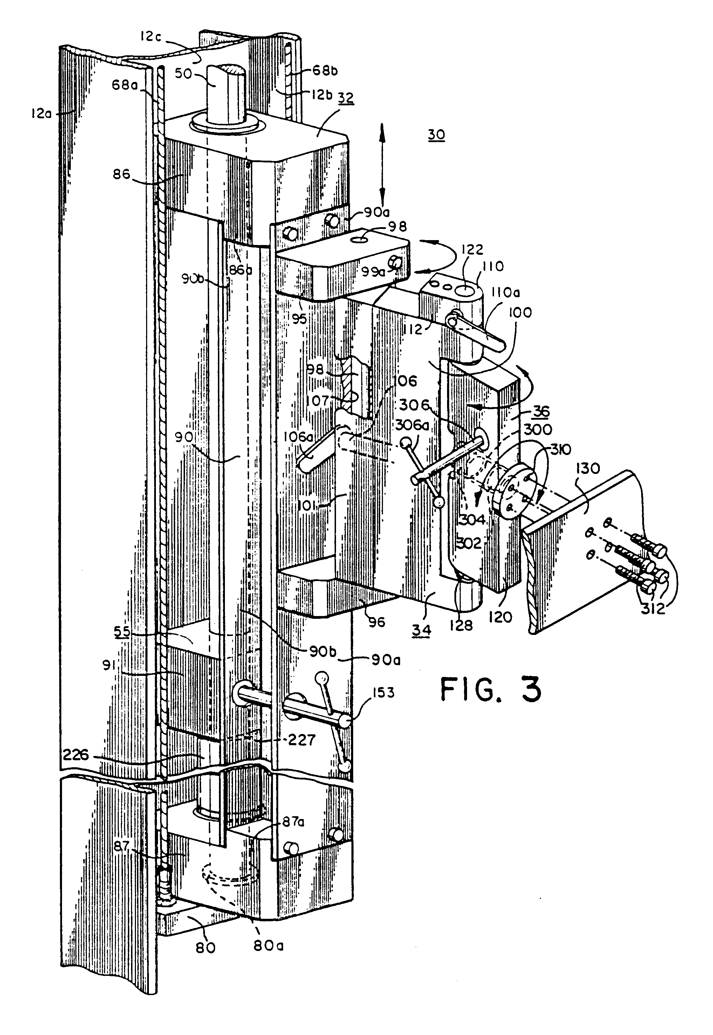

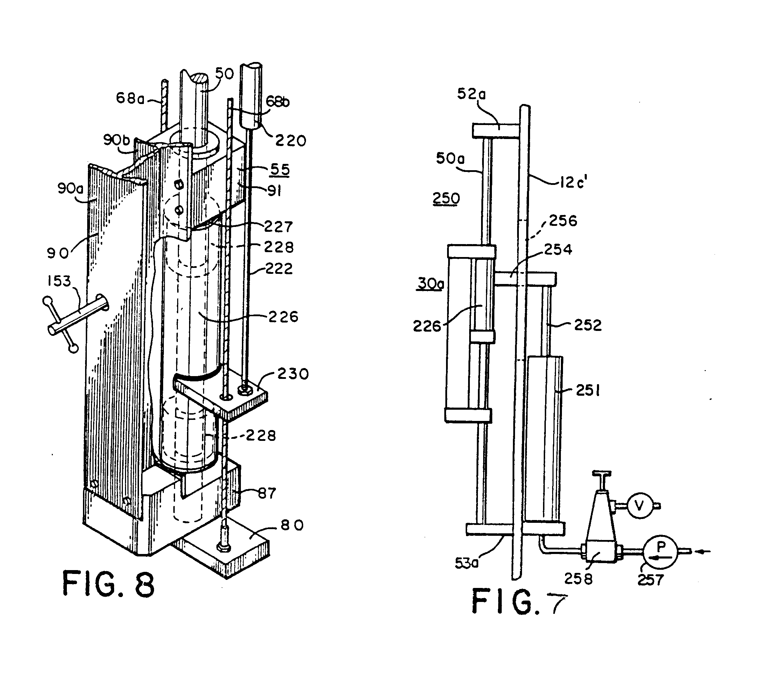

As shown in Figs. 3, 8, main arm assembly 32 includes an upper bearing block 86 and a lower bearing block 87 carried by block 80. A main shaft thrust bearing 80a is provided between blocks 80, 87. Blocks 86, 87 have respective lower extending and upper extending sections 86a, 87a and as shown engage an I beam 90. Specifically, a front wall 90a of I beam 90 is secured to front faces of blocks 86, 87 while a rear section 90b of I beam 90 is secured to sections 86a, 87a. The vertical and rotational movements of assembly 32 may be temporarily locked in any position by means of a lock 55 formed in a block 91 as later described in detail. A sleeve 87, 91 having inner linear bearings 228 which permit the sleeve to travel upwardly and downwardly on shaft 50. Further, sleeve 226 has thrust bearings 227. In this way a unitary main arm assembly 32 is formed which is adapted to have vertical movement and rotational movement (about a vertical axis) on a vertical shaft 50.

To provide velocity sensitive viscous damping for assembly 32, a fluid cylinder 220 has one end fixed to pillow block 52 and the other end to plate 230 secured to the outer surface of sleeve 226. Cylinder 220 prevents rapid vertical movement of arm assembly 30 as a safety feature for operating personnel and to prevent damage to the handler and test head.

Secured to front face 90a are a pair of pillow blocks 95, 96 of forearm assembly 34. A vertical shaft 98 extends through pillow blocks 95, 96. Forearm assembly 34 further includes a forearm 100 having a rear section 101 which is bolted to forearm 100 by means of bolts. Shaft 98 extends through vertical opening 107 in section 101 with needle bearings at either end and a thrust bearing between section 101 and pillow block 96. Forearm assembly 34 may be temporarily fixed in its rotational position about a vertical axis by means of a forearm lock assembly 106.

It will be understood that forearm assembly 34 may be effectively turned 180° while maintaining all the other elements in their original positions. In this manner, rear section 101 extends to the left as compared to the right as shown in Fig. 3.

Forearm 100 has a front "C" shaped section which rotatively receives an attachment member 120 of wrist joint assembly 36. Member 120 rotates with respect to forearm 100 by way of vertical upper and lower pivot pins 122. Needle bearings are provided for the rotation of pins 122 in forearm 100 and a thrust bearing 128 is provided between member 120 and forearm 100. Member 120 may be temporarily prevented from rotation with respect to assembly 34 by means of a wrist joint lock assembly 110 which is formed within a block 112 secured to the upper surface of forearm 100.

Member 120 has a longitudinal opening for receiving a horizontally extending shaft 300 which is rotated within needle bearings 302 and 304 secured to member 120. Shaft 300 at its outer end is welded to a connecting hub 310 for threadedly receiving cap screws 312 to rigidly secure back plate 130 of cradle assembly 38.

Cradle assembly 38 is formed by three walls 130-132 welded together to form a U-shaped holder for the test head. Shaft 300 is effective to allow the rotation of assembly 38 about a horizontal axis and assembly 38 may be secured in position by tightening of cradle lock assembly 306 which is similar to assembly 55.

Walls 131, 132 receive test head adapter plates 40a,b and allow these plates to rotate with respect to the walls and then to be rigidly fixed in position. Since the structure of both plates 40 a,b are the same only one of them need be described . Arm 131 has within an end section a circular groove 135 and an opening 136 for receiving a shoulder screw 137. A lock knob 140 is threaded into plate 40a and moves about circular groove 135 in conventional manner. In this way, by tightening lock knob 140, plate 40a is rigidly secured with respect to wall 131.

It will now be understood that test head positioner system 10 simultaneously positions in six degrees of freedom, X, Y, Z, $\theta_X$, $\theta_Y$, $\theta_Z$. As shown in Fig. 6, it is important for the proper docking of test head 11 that the test connector 11a have that six degrees of freedom so that it can accurately and effortlessly be positioned with respect to the device to be tested, 15a for example. If the Y direction were considered to be the vertical or up/down direction then the movement of assembly 32 vertically with respect to shaft 50 provides the Y direction of freedom. $\theta_Y$ freedom, which is the rotation about the Y axis is then provided by simultaneous rotation of all of the joints about vertical axes 50, 98 and 122.

If the X direction were considered to the left to right direction, then that freedom is provided by pivots 50, 98 and 122 in the same manner as $\theta y$. The $\theta x$ freedom is provided by shoulder screw pivot 137. With respect to Z movement which may be considered to be the in and out movement, such freedom is provided by pivot shafts 50, 98 and 122 in the same way as $\theta y$. $\theta z$ is then provided by the pivoting of shaft 300.

Referring now to Fig. 4, there is shown a main arm assembly lock 55 which comprises a conventional wedge lock system. Specifically, two wedges 150 and 152 are provided on either side of shaft 50 and are threadedly engaged by threads 154 of a lock handle 153. By turning lock handle 153 clockwise, wedge members 150, 152 are brought together and apply pressure onto shaft 50 and this way prevent rotation of block 91 about shaft 50 and also prevent a vertical movement of block 91 and the entire assembly 30. Similar lock assemblies are provided for forearm lock assembly 106, wrist joint lock assembly 110 and cradle lock assembly 306 which have turning arms 106a, 110a, 306a respectively.

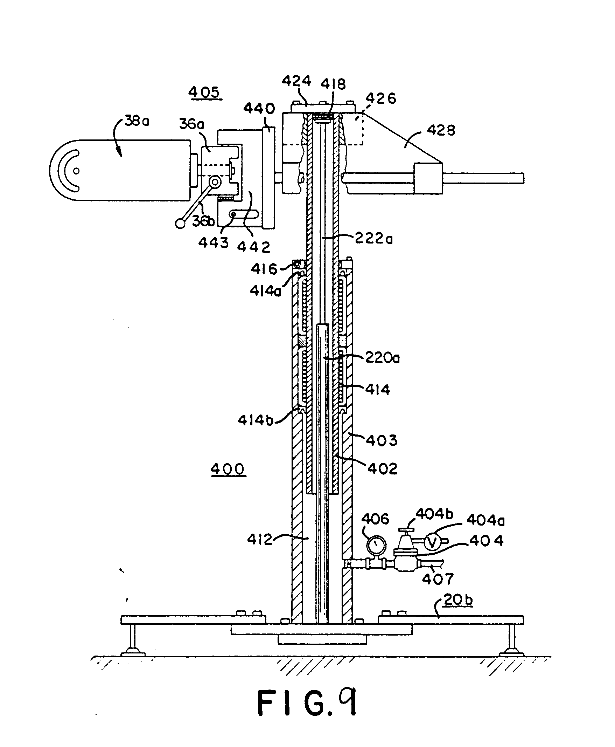

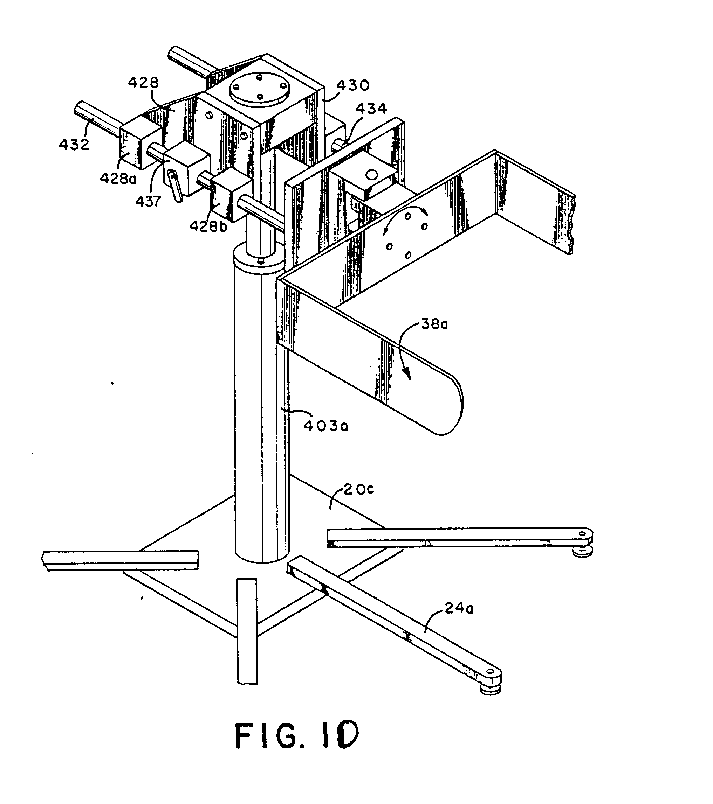

Still another embodiment of the invention is shown in Fig. 7 in which system 250 replaces the weights and cable assembly 60, 68a,b of system 10 with a pressurized cylinder 251 having a piston 252. Cylinder 251 effectively provides the same function as counterbalance assembly 60 in that it produces a constant force on arm assembly 30a (including test head 11) counter to gravity regardless of the actual position of the assembly. The balancing of different weights of assembly 30a may be accomplished by maintaining a constant pressure within the cylinder 251 by means of a regulator 258 supplied by pump 257 and described in detail with respect to Figs. 9,10.

Cylinder 251 is rigidly secured to central web 12c' of column 12 of Fig. 1. Piston 252 extends upwardly and is fixedly connected to a horizontal arm 254 which extends through a slot 256 formed in web 12c'. At its other end, arm 254 is fixedly welded to sleeve 226, Figs. 1,8. In all other respects, system 250 is substantially similar to system 10.

Referring now to Figs. 9 & 10, there is shown the embodiment claimed in which vertical column 12 of system 10 is in system 400 replaced by a vertically displaced cylindrical support tube 403. A first arm unit 402 is coupled to the support tube 403 for allowing vertical movement with respect to the support tube 403 Tube 403 forms a cylinder for first arm unit 402 ( a piston and telescoping rod) with seals 414a,b. As in systems 10 and 250, support tube 403 is supported at its bottom by a base assembly 20b having extending legs 24a-e. Tube 403 and first arm unit 402 operate the same as tube 251 and piston 252.

4

A second arm unit 405 is coupled to the first arm unit 402. The second arm unit includes a test head receiving unit 38a. In the embodiment of the present invention, the second arm unit 405 including test head. receiving unit. 38a are similar to assembly 30 but are designed for further simplicity. Specifically, rotation and vertical movement of first arm unit 402 may be locked by a lock assembly 416, as shown. The upper section of first arm unit 402 is rigidly secured to mount block 426 to which is secured bearing mount plates 428, 430. Plate 428 has secured to its outer face bearing blocks 428a,b and similarly plate 430 has blocks 430a,b. These blocks have linear bearings for receiving horizontal shafts 432,434 respectively. Locking block 437 secured to plate 428 is effective to receive shaft 432 and prevent movement thereof when locked. Shafts 432, 434 are rigidly connected at their left end to a rotational means mounting plate 440 which fixedly carries a rotational means bearing block 442 having a lock assembly 443 similar to assembly 110. Block 442 has secured to an inner section thereof a rotational means assembly 36a carrying a test head receiving unit 38a which are similar to assemblies 36 , 38 of system 10. As shown in Fig. 9, rotational means assembly 36a allows the test head to be rotated about a vertical axis. In the embodiment of the present invention, test head receiving unit 38a is coupled to rotational means assembly 36a to allow rotation about a horizontal axis.

In operation, a fluid cavity 412 is formed between the first arm unit (or the piston) and the cylinder. Fluid under pressure flows into and out of the cavity from a fluid source coupled by way of a line 407 through a regulator 404, and pressure gauge 406 to cavity 412. In conventional manner regulator 404 has an opening to atmosphere 404a which allows pressure from cavity 412 to be released when it is in excess of the regulator setting 404b. In a preferred example, the fluid is air under a pressure of 172 to 688 kilonewtons per sguare meter. This would accommodate a total weight of the first arm unit, the second arm unit and the test head receiving unit including a test head where the test head weights from 34 to 136 kilograms. In this manner there is achieved a constant pressure "gas spring" so that the moveable components effectively achieve weightlessness. When it is desired to manually move the position of the test head up or down, the fluid volume in cavity 412 changes which is immediately compensated for by pressure regulator 404. Preferably, the test head may have .38 to .51 meters of vertical travel.

Within first arm unit 402 there is disposed a damper 220a having a damper rod 222a which is similar to that shown in Fig. 1. The top end of damper 220a is journaled in a bearing 418 connected to an upper plate 424 of arm assembly 405. In this manner, damper 220a is effective to damp the movement of assembly 405 while the rotation of the assembly does not adversely twist rod 222a.

In operation as in system 10 all of the locks of positioner system 400 are open and then the test head is moved to its desired position. That is, second arm unit 405 may turn about cylinder 403 as well as horizontally by way of shafts 432, 434 and then to other positions determined by assemblies 442, 36a and 38a. It will be understood that shafts 432, 434 by providing horizontal movement, eliminate the need for forearm shaft 98 while still providing the above described six degrees of freedom.

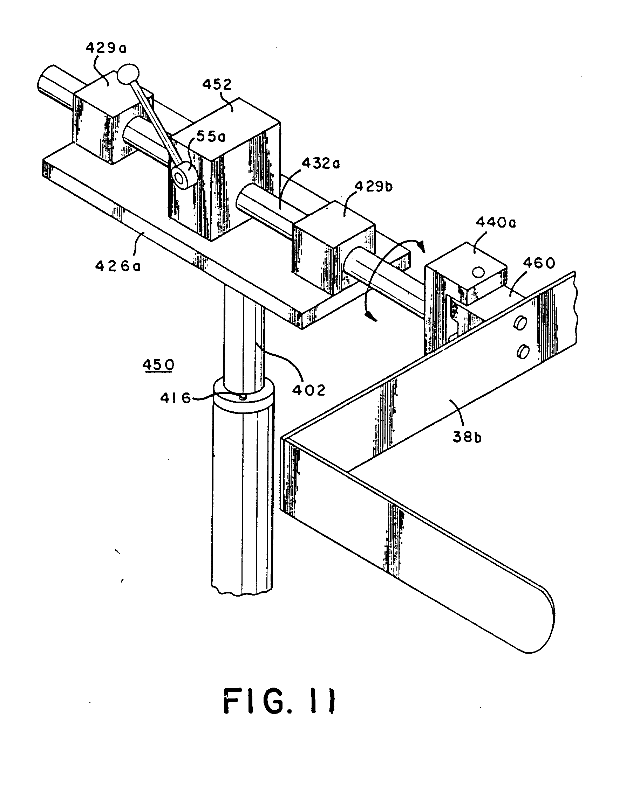

A modification of positioner system 400 is shown in Fig. 11 as Positioner system 450. Positioner system 450 is suitable for relatively lightweight test heads since it is a simplified construction having a single shaft 432a horizontally journaled in blocks 429a,b and 452. Blocks 429a,b and 452 are carried by and secured to a mount block 426a which is supported by piston 402. The horizontal and rotational movement of the shaft 432a is locked by previously described wedge lock system 55a within block 452. Further, the end of shaft 432a is rigidly secured to a wrist bearing block 440a. Block 440a supports a simplified wrist joint assembly 460 which carries cradle assembly 38b. Suitable locks are provided in blocks 440a, 460 and assembly 38b in the manner previously described.

## Claims

1. A system for maintaining an electronic test head in a substantially weightless condition for manually docking and undocking the test head with respect to an electronic device handler characterized in that it comprises;

   support, means (403) defining a first vertical axis;

   a first arm unit (402) coupled to the support means for allowing vertical movement with respect to the support means;

   a second arm unit (405) coupled to the first arm unit, the second arm unit including a test head receiving unit (38a) mounted to provide pivotal movement about a horizontal axis;

   continuously horizontal linear motion guide means (432,434) for providing only horizontal movement of the test head with respect to the support means; and

   rotational means (36a) mounted so as to preclude linear vertical movement relative to the second arm unit for providing rotational movement of the test head about a second vertical axis; the first

5

vertical axis and the second vertical axis being always oriented vertically; and

the second arm unit (405) being mounted so as to preclude vertical movement relative to the first arm unit (402); and

counterbalancing means (60, 220a) coupled to the first arm unit (402) for providing a substantially weightless condition to the test head receiving unit (38a) with the test head mounted thereto, the test head being free to rotate about at least one of the first vertical axis and the second vertical axis as the test head is manually extended for docking and undocking of the test head with the electronic device handler.

2. The system of claim 1 in which the continuously horizontal linear motion guide means is a single horizontal guide (432a).

**Revendications**

1. Système pour maintenir une tête de test électronique dans une condition sensiblement d'apesanteur pour arrimer et désarrimer manuellement la tête de test par rapport à un manipulateur à dispositif électronique, caractérisé en ce qu'il comprend :

un moyen support (403) définissant un premier axe vertical ;

une première unité de bras (402) couplée au moyen support pour permettre un mouvement vertical par rapport au moyen support ;

une seconde unité de bras (405) couplée à la première unité de bras, la seconde unité de bras comportant une unité réceptrice de tête de test (38a) montée pour assurer un mouvement de pivotement autour d'un axe horizontal ;

un moyen de guide à déplacement linéaire horizontal continu (432, 434) pour assurer seulement un mouvement horizontal de la tête de test par rapport au moyen support ; et

un moyen rotatif (36a) monté de façon à empêcher le mouvement relatif vertical linéaire de la seconde unité de bras pour assurer un mouvement de rotation de la tête de test autour d'un second axe vertical ; le premier axe vertical et le second axe vertical étant toujours orientés verticalement ; et

la seconde unité de bras (405) étant montée de façon à empêcher le mouvement relatif vertical de la première unité de bras (402) ; et

des moyens d'équilibrage (60, 220a) couplés à la première unité de bras (402) pour assurer une condition sensiblement d'apesanteur à l'unité réceptrice de tête de test (38a) lorsque la tête de test est montée sur elle, la tête de test étant libre en rotation autour d'au moins l'un du premier axe vertical et du second axe vertical lorsque la tête de test est étendue à la main pour arrimer et désarrimer la tête de test sur le manipulateur à dispositif électronique.

2. Système selon la revendication 1 dans lequel le moyen de guide à déplacement linéaire horizontal continu est un guide horizontal unique (432a).

**Patentansprüche**

1. System zur Beibehaltung eines elektronischen Testkopfes in einem im wesentlichen gewichtslosen Zustand für ein manuelles Andocken und Entdocken des Testkopfes in Bezug auf einen elektronischen Vorrichtungs-Handhaber, gekennzeichnet durch

Stützmittel (403), die eine erste Vertikalachse definieren;

eine erste Armeinheit (402), die mit den stützmitteln gekoppelt ist, um eine Vertikalbewegung in Bezug auf die Stützmittel zu ermöglichen;

eine zweite Armeinheit (405), die mit der ersten Armeinheit gekoppelt ist, wobei die zweite Armeinheit eine den Testkopf aufnehmende Einheit (38a) umfaßt, welche zur Bereitstellung einer Schwenkbewegung um eine Horizontalachse vorgesehen ist;

Horizontal-Linearbewegung-Stetigführungsmittel (432, 434) für die Bereitstellung nur einer Horizontalbewegung des Testkopfes in Bezug auf die Stützmittel; und

Rotationsmittel (36a), welche derart angeordnet sind, daß eine lineare Vertikalbewegung relativ zu der zweiten Armeinheit für die Bereitstellung einer Rotationsbewegung des Testkopfes um eine zweite Vertikalachse verhindert wird, wobei die erste Vertikalachse und die zweite Vertikalachse immer vertikal ausgerichtet sind; und

die zweite Armeinheit (405) derart angeordnet ist, daß eine Vertikalbewegung relativ zu der ersten Armeinheit (402) verhindert wird; und

gegen Gewichtmittel (60, 220a) die mit der ersten Armeinheit (402) gekoppelt sind, um einen im wesentlichen gewichtslosen Zustand der den Testkopf aufnehmenden Einheit (38a) bereitzustellen, wenn der Testkopf daran montiert ist, wobei der Testkopf sich um wenigstens eine der beiden ersten und zweiten Vertikalachsen drehen kann, wenn der Testkopf für ein Andocken oder Entdocken des Testkopfes mit dem elektronischen Vorrichtungs-Handhaber manuell ausgefahren wird.

2.  System nach Anspruch 1, bei welchem die Horizontal-Linearbewegung-Stetigführungsmittel eine einzige Horizontalführung (432a) sind.

FIG.1

FIG. 2

FIG. 3

FIG. 4

FIG. 5

FIG. 6

FIG. 8

FIG. 7

FIG. 9

FIG. 1D

FIG. 11